**Europäisches Patentamt**

**European Patent Office**

**Office européen des brevets**

(19)

(11) Veröffentlichungsnummer: **0 134 268**
**B1**

(12)

# EUROPÄISCHE PATENTSCHRIFT

(45) Veröffentlichungstag der Patentschrift:
**19.11.87**

(21) Anmeldenummer: **83107874.6**

(22) Anmeldetag: **09.08.83**

(51) Int. Cl.⁴: **G 01 B 5/00,** G 03 B 41/00,
B 23 Q 1/14

(54) **Justier- oder Positioniertisch und Verfahren zu dessen Herstellung.**

(43) Veröffentlichungstag der Anmeldung:
**20.03.85 Patentblatt 85/12**

(45) Bekanntmachung des Hinweises auf die Patenterteilung:
**19.11.87 Patentblatt 87/47**

(84) Benannte Vertragsstaaten:
**AT CH DE FR GB IT LI SE**

(56) Entgegenhaltungen:
**CH - A - 485 328**
**DE - A - 3 116 190**
**FR - A - 2 223 865**

(73) Patentinhaber: **Siemens Aktiengesellschaft Berlin und München, Wittelsbacherplatz 2, D-8000 München 2 (DE)**

(72) Erfinder: **Eigenstetter, Herbert,**
**Alexander-Fleming-Strasse 107, D-8033 Planegg (DE)**

**Beschreibung**

Die Erfindung betrifft einen Justier- oder Positioniertisch, insbesondere für Feinverstellungen im Submikrometerbereich nach dem Oberbegriff des Anspruchs 1, sowie ein Verfahren zur Herstellung eines Justier- oder Positioniertisches, insbesondere für Feinverstellungen im Submikrometerbereich nach dem Oberbegriff des Anspruchs 19.

In der Halbleitertechnik werden mit Hilfe von Masken feinste Strukturen auf Siliziumscheiben übertragen, wobei eine hochgenaue Justierung von Maske zu Scheibe verlangt wird. So erfordert beispielsweise die Übertragung von Strukturen im Submikrometerbereich durch die Röntgenlitographie eine Justierung von Maske zu Scheibe mit Genauigkeiten im Bereich unter 0,1 μm. Derartige genaue Positioniervorgänge können durch herkömmliche Justier- oder Positioniertische mit Kugelführungssystemen nicht bewerkstelligt werden.

Aus dem Aufsatz «Blattfederelemente für Messvorrichtungen» von R. Breitinger in der Zeitschrift «Werkstattstechnik» 59. Jahrgang 1969, Heft 2, S. 78 bis 83, ist ein Justier- oder Positioniertisch der eingangs genannten Art bekannt, welcher als einfache Parallelführung oder als Doppelparallelführung ausgebildet ist und eine lineare Verstellung des beweglichen Tischteils erlaubt. Bei diesem bekannten, für kleine lineare Verstellungen konzipierten Justier- oder Positioniertisch sind der fest angeordnete Tischteil und der bewegliche Tischteil durch als Blattfedern ausgebildete Federgelenke miteinander verbunden. Die Verbindung der Blattfedern mit dem fest angeordneten Tischteil und dem beweglichen Tischteil erfolgt mit Hilfe von Klemmbacken, die mit dem betreffenden Tischteil verschraubt werden. Eine derartige Einspannung der Blattfedern kann jedoch nicht mit der für Feinverstellungen im Submikrometerbereich erforderlichen Genauigkeit hergestellt werden. Durch die ungenügende Reproduzierbarkeit der geometrischen Bedingungen und der Reibungseinflüsse beim Zusammenbau ergeben sich insbesondere unterschiedliche Eigenschaften der Blattfedern und nicht reproduzierbare Bahnkurven des beweglichen Tischteils.

Der Erfindung liegt die Aufgabe zugrunde, einen für Feinverstellungen im Submikrometerbereich geeigneten Justier- oder Positioniertisch zu schaffen, bei welchem reproduzierbare Eigenschaften der Federgelenke gewährleistet sind.

Diese Aufgabe wird bei einem gattungsgemässen Justier- oder Positioniertisch durch die kennzeichnenden Merkmale des Anspruchs 1 gelöst.

Der Erfindung liegt die Erkenntnis zugrunde, dass durch die einstückige Herausbildung des fest angeordneten Tischteils, des beweglichen Tischteils und der Federgelenke aus einer gemeinsamen Tischplatte Einspannungenauigkeiten der Federgelenke vermieden werden und gleiche Eigenschaften sämtlicher Federgelenke erzielt werden können. Ausserdem ist durch die paarweise Anordnung von mindestens vier Federgelenken auf gegenüberliegenden Seiten des beweglichen Tischteils eine genaue Parallelführung des beweglichen Tischteils ohne jegliche Verdrehung oder auch eine genaue Drehbewegung des beweglichen Tischteils ohne jegliche Translation gewährleistet. Ein weiterer Vorteil der einstückigen Ausbildung ist, dass sämtliche Teile mit absoluter Sicherheit aus dem gleichen Material der gleichen Charge bestehen und somit die Positionsstabilität durch ungleiche Wärmedehnungen nicht beeinträchtigt werden kann. Überdies können durch die einstückige Ausbildung grosse Massen der Tischteile realisiert werden, die aufgrund ihrer grossen Wärmekapazität bei Temperaturschwankungen ebenfalls zur Positionsstabilität beitragen.

Das erfindungsgemässe Prinzip der einstückigen Ausbildung von festem Tischteil, mindestens einem beweglichen Tischteil und den entsprechenden Federgelenken durch die Herausbildung aus einer gemeinsamen Tischplatte kann bei Justier- oder Positioniertischen mit linearer Verstellung in einer Richtung, mit Drehverstellung und mit linearer Verstellung in zwei zueinander senkrechten Richtungen angewandt werden. Selbst eine Integration aller für eine lineare Verstellung in zwei Richtungen und eine Drehverstellung erforderlichen Teile in einer gemeinsamen Tischplatte ist möglich. Hierbei wird durch die Integration der verschiedenen Verstellungen die Positionsstabilität wesentlich erhöht, da bei einer Zusammensetzung aus einzelnen Komponenten durch deren räumliche Trennung nur eine begrenzte Positionsstabilität bei Temperaturschwankungen erzielt werden kann.

Besonders hervorzuheben ist eine weitere Ausgestaltung der Erfindung, bei welcher die Federgelenke jeweils durch vier in den Eckpunkten eines Rechtecks in die gemeinsame Tischplatte eingebrachte Bohrungen und durch zwei parallel zueinander in die gemeinsame Tischplatte eingebrachte und jeweils zwei Bohrungen miteinander verbindende Schlitze gebildet sind. Dabei entstehen zwischen jeweils zwei Bohrungen Einschnürungen, die als elastisch deformierbare Drehgelenke wirken. Demgegenüber ist der mittlere, durch die beiden parallelen Schlitze begrenzte Bereich der Federgelenke als Verdickung ausgebildet, welche als Versteifung der Federgelenke wirkt. Eine derartive Versteifung ist insbesondere dann zu empfehlen, wenn an einem beweglichen Tischteil mehrere Einzelkräfte angreifen können und Knickung und Torsion der Federgelenke zu befürchten sind. Durch die Möglichkeit, die Bohrungen mit höchster Präzision in die gemeinsame Tischplatte einzubringen, können die Federlängen und die wirksamen Querschnitte der Federgelenke mit entsprechend hoher Präzision vorgegeben werden, was zu einer hohen Reproduzierbarkeit des Kraft-Weg-Verhaltens der beweglichen Tischteile führt.

Weitere vorteilhafte Ausgestaltungen der Erfindung sind in den abhängigen Ansprüchen 2 bis 18 angegeben.

Die Erfindung gibt ferner ein Verfahren der eingangs genannten Art zur Herstellung eines Justier- oder Positioniertisches an, bei welchem aus einer gemeinsamen Tischplatte ein fest angeordneter Tischteil, mindestens ein beweglicher Tischteil und mindestens vier zwischen dem fest angeordneten Tischteil und dem beweglichen Tischteil angeordnete Federgelenke durch Funkenerosion herausgebildet werden. Die Funkenerosion ist für das Herausbilden der einzelnen Teile aus der gemeinsamen Tischplatte besonders gut geeignet, da sie hohe Ansprüche an die Mass- und Formhaltigkeit sowie an die Oberflächengüte des bearbeiteten Werkstückes erfüllt.

Vorteilhafte Ausgestaltungen des genannten Verfahrens gehen aus den abhängigen Ansprüchen 20 bis 22 hervor.

Ausführungsbeispiele der Erfindung sind in der Zeichnung dargestellt und werden im folgenden näher beschrieben. Es zeigen:

Fig. 1 einen Justier- oder Positioniertisch mit linearer Verstellung in zwei zueinander senkrechten Richtungen in stark vereinfachter schematischer Darstellung;

Fig. 2 einen Justier- oder Positioniertisch mit reiner Drehverstellung in stark vereinfachter schematischer Darstellung;

Fig. 3 einen Justier- oder Positioniertisch mit linearer Verstellung in zwei zueinander senkrechten Richtungen und einer zusätzlichen Drehverstellung in stark vereinfachter schematischer Darstellung;

Fig. 4 einen Justier- oder Positioniertisch mit linearer Verstellung in zwei zueinander senkrechten Richtungen in der Draufsicht;

Fig. 5 in vergrössertem Massstab die einstückige Verbindung eines Federgelenkes mit den beiden benachbarten Tischteilen bei dem Justier- oder Positioniertisch gemäss Fig. 4;

Fig. 6 die Kontur des Federgelenks nach Fig. 5, und

Fig. 7 einen Justier- oder Positioniertisch mit reiner Drehverstellung in der Draufsicht.

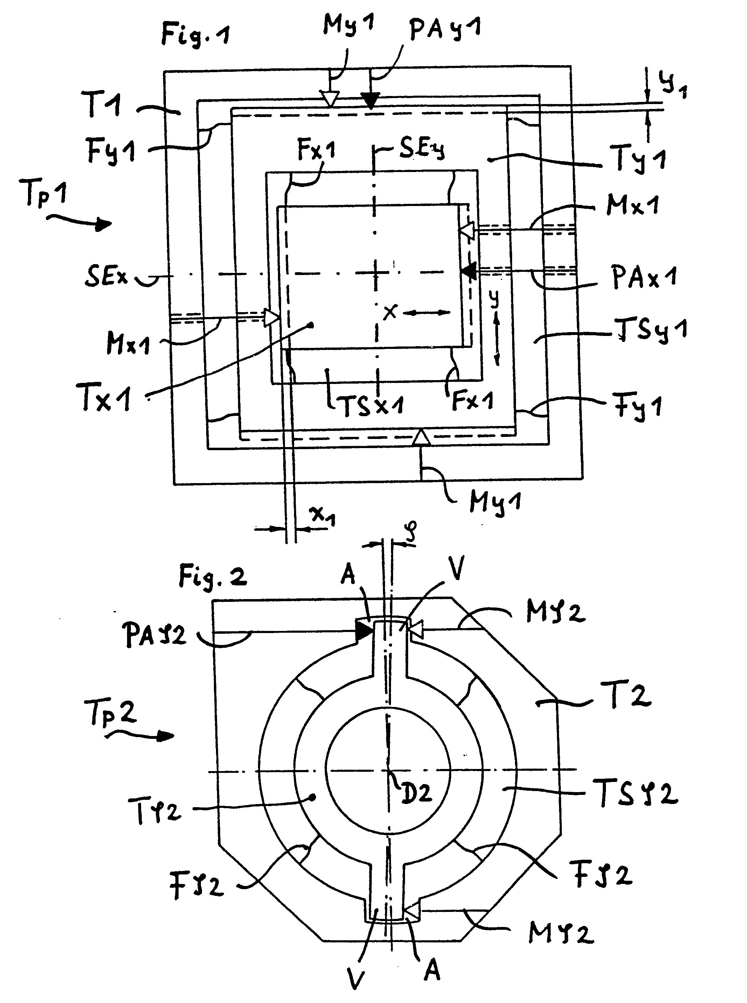

Fig. 1 zeigt einen Justier- oder Positioniertisch aus dessen gemeinsamer Tischplatte $Tp1$ ein fest angeordneter Tischteil $T1$, ein erster in der y-Richtung beweglicher Tischteil $Ty1$, ein zweiter in der x-Richtung beweglicher Tischteil $Tx1$, vier paarweise zwischen dem fest angeordneten Tischteil $T1$ und dem ersten beweglichen Tischteil $Ty1$ angeordnete Federgelenke $Fy1$ und vier weitere paarweise zwischen dem ersten beweglichen Tischteil $Ty1$ und dem zweiten beweglichen Tischteil $Tx1$ angeordnete Federgelenke $Fx1$ einstückig herausgebildet sind. Um diese einstückige Ausbildung der vorstehend aufgeführten Teile zu erzielen, werden zwischen den fest angeordneten und einen äusseren Rahmen bildenden Tischteil $T1$ und den ersten beweglichen Tischteil $Ty1$ sich zwischen den Federgelenken $Fy1$ erstreckende Trenn-Schlitze $TSy1$ und in entsprechender Weise zwischen den ersten beweglichen Tischteil $Ty1$ und den zweiten beweglichen Tischteil $Tx1$ sich zwischen den weiteren Federgelenken $Fx1$ erstreckende Trenn-Schlitze $TSx1$ in die gemeinsame Tischplatte $Tp1$ eingebracht. Die Federgelenke $Fy1$ sind senkrecht zur y-Richtung ausgerichtet und spiegelsymmetrisch zu einer in der y-Richtung liegenden Symmetrie-Ebene $SEy$ der gemeinsamen Tischplatte $Tp1$ angeordnet. Dementsprechend sind die weiteren Federgelenke $Fx1$ senkrecht zur x-Richtung ausgerichtet und spiegelsymmetrisch zu einer in der x-Richtung liegenden Symmetrie-Ebene $SEx$ der gemeinsamen Tischplatte $Tp1$ angeordnet.

Eine genaue lineare Verstellung des ersten beweglichen Tischteils $Ty1$ in der y-Richtung bei entsprechender Auslenkung der Federgelenke $Fy1$ wird durch einen als Stellantrieb vorgesehenen Piezo-Antrieb $PAy1$ ermöglicht, welcher durch den fest angeordneten Tischteil $T1$ hindurch auf den ersten beweglichen Tischteil $Ty1$ einwirkt und in der Zeichnung nur durch einen Pfeil angedeutet ist. Eine entsprechende lineare Verstellung des ersten beweglichen Tischteils $Ty1$ ist durch den Verstellweg $y_1$ aufgezeigt.

Eine genaue lineare Verstellung des zweiten beweglichen Tischteils $Tx1$ in der x-Richtung bei entsprechender Auslenkung der weiteren Federgelenke $Fx1$ wird durch einen als Stellglied vorgesehenen Piezo-Antrieb $PAx1$ ermöglicht, welcher durch den fest angeordneten Tischteil $T1$ und den ersten beweglichen Tischteil $Ty1$ hindurch auf den zweiten beweglichen Tischteil $Tx1$ einwirkt und in der Zeichnung nur durch einen Pfeil angedeutet ist. Eine entsprechende lineare Verstellung des zweiten beweglichen Tischteils $Tx1$ ist durch den Verstellweg $x_1$ aufgezeigt.

Zur Erfassung der Ist-Position des ersten beweglichen Tischteils $Ty1$ sind zwei in Differenz geschaltete und auf gegenüberliegenden Seiten durch den fest angeordneten Tischteil $T1$ hindurchgeführte, induktive Messtaster $My1$ vorgesehen, welche in der Zeichnung nur durch Pfeile angedeutet sind. In entsprechender Weise sind zur Erfassung der Ist-Position des zweiten beweglichen Tischteils $Tx1$ zwei in Differenz geschaltete und auf gegenüberliegenden Seiten durch den fest angeordneten Tischteil $T1$ und den ersten beweglichen Tischteil $Ty1$ hindurchgeführte induktive Messtaster $Mx1$ vorgesehen, welche in der Zeichnung ebenfalls nur durch Pfeile angedeutet sind.

Die beiden Piezo-Antriebe $PAy1$ und $PAx1$ weisen ein Hystereseverhalten auf, d.h. sie können nach einer Verstellung um mehrere 0,1 μm driften. Aus diesem Grund wird über einen in der Zeichnung nicht dargestellten Regelkreis ein automatischer Soll-Ist-Vergleich durchgeführt, so dass die Piezo-Antriebe $PAy1$ und $PAx1$ so lange nachgeregelt werden können, bis die gewünschte Soll-Position erreicht ist. Andererseits wird durch die Differenz-Schaltung der beiden induktiven Messtaster $My1$ und der beiden induktiven Messtaster $Mx1$ erreicht, dass sich Längenänderungen durch Temperaturschwankungen sowohl in den Messtastern als auch in den Feinverstellungen selbst kompensieren.

Fig. 2 zeigt einen Justier- oder Positioniertisch aus dessen gemeinsamer Tischplatte $Tp2$ ein fest angeordneter Tischteil $T2$, ein um eine Drehachse $D2$ verdrehbarer Tischteil $Tφ2$ und vier radial ausgerichtete und zwischen dem fest angeordneten Tischteil T2 und dem verdrehbaren Tischteil Tφ2 angeordnete Federgelenke Fφ2 einstückig herausgebildet sind. Um diese einstückige Ausbildung der vorstehend aufgeführten Teile zu erzielen, werden zwischen den fest angeordneten und einen äusseren Rahmen bildenden Tischteil T2 und den verdrehbaren Tischteil Tφ2 sich zwischen den Federgelenken Fφ2 im wesentlichen in Umfangsrichtung erstreckende Trenn-Schlitze TSφ2 in die gemeinsame Tischplatte Tp2 eingebracht. An zwei gegenüberliegenden Stellen nehmen die Trenn-Schlitze TSφ2 dabei einen derartigen Verlauf, dass in Aussparungen A des fest angeordneten Tischteils T2 eingreifende Vorsprünge V des verdrehbaren Tischteils Tφ2 gebildet werden. Im Bereich einer dieser Aussparungen A ist ein als Stellantrieb vorgesehener Piezo-Antrieb PAφ2 angeordnet, welcher durch den fest angeordneten Tischteil T2 hindurchgeführt und in der Zeichnung nur durch einen Pfeil angedeutet ist. Zur Erfassung der Ist-Position des verdrehbaren Tischteils Tφ2 ist im Bereich jeder Aussparung A jeweils ein induktiver Messtaster Mφ2 angeordnet. Die beiden durch den fest angeordneten Tischteil T2 hindurchgeführten und in Differenz geschalteten induktiven Messtaster Mφ2 sind dabei in der Zeichnung ebenfalls nur durch Pfeile angedeutet.

Durch den auf einen Vorsprung V einwirkenden Piezo-Antrieb PAφ2 wird bei entsprechender Auslenkung der vier rotationssymmetrisch zur Drehachse D2 angeordneten Federgelenke Fφ2 eine reine Drehverstellung des verdrehbaren Tischteils Tφ2 ermöglicht. Eine entsprechende Drehverstellung des verdrehbaren Tischteils Tφ2 ist durch den Verdrehwinkel φ aufgezeigt. Die Nachregelung des Piezo-Antriebs PAφ2 bis zum Erreichen der gewünschten Soll-Position erfolgt wie bei dem Ausführungsbeispiel nach Fig. 1 durch einen entsprechenden Regelkreis.

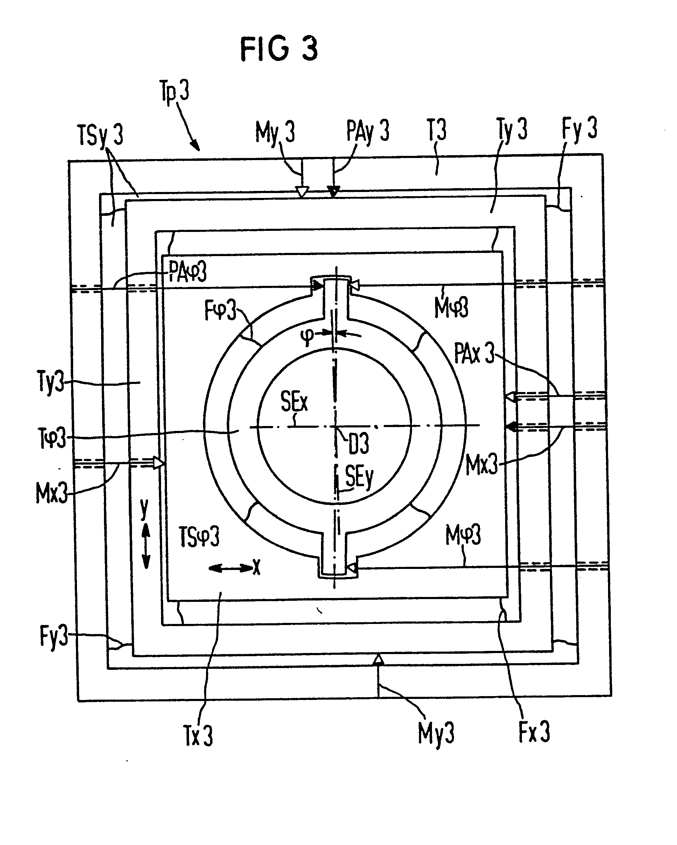

Fig. 3 zeigt einen Justier- oder Positioniertisch, aus dessen gemeinsamer Tischplatte Tp3 ein fest angeordneter Tischteil T3, ein erster in der y-Richtung beweglicher Tischteil Ty3, ein zweiter in der x-Richtung beweglicher Tischteil Tx3, ein dritter um eine Drehachse D3 verdrehbarer Tischteil Tφ3, vier paarweise zwischen dem fest angeordneten Tischteil T3 und dem ersten beweglichen Tischteil Ty3 angeordnete Federgelenke Fy3, vier weitere, paarweise zwischen dem ersten beweglichen Tischteil Ty3 und dem zweiten beweglichen Tischteil Tx3 angeordnete Federgelenke Fx3 und vier zusätzliche, radial ausgerichtete und zwischen dem zweiten beweglichen Tischteil Tx3 und dem dritten, verdrehbaren Tischteil Tφ3 angeordnete Federgelenke Fφ3 einstückig herausgebildet sind. Um diese einstückige Ausbildung der vorstehend aufgeführten Teile zu erzielen, werden zwischen den fest angeordneten Tischteil T3, den ersten beweglichen Tischteil Ty3, den zweiten beweglichen Tischteil Tx3 und den dritten verdrehbaren Tischteil Tφ3 Trenn-Schlitze TSy3 bzw. TSx3 bzw. TSφ3 eingebracht, welche sich jeweils zwischen den entsprechenden Federgelenken Fy3 bzw. Fx3 bzw. Fφ3 erstrecken.

Als Stellantriebe für den ersten beweglichen Tischteil Ty3, den zweiten beweglichen Tischteil Tx3 und den dritten verdrehbaren Tischteil Tφ3 sind Piezo-Antriebe PAy3 bzw. PAx3 bzw. PAφ3 vorgesehen, welche in der Zeichnung nur durch Pfeile angedeutet sind. Zur Erfassung der Ist-Positionen des ersten beweglichen Tischteils Ty3, des zweiten beweglichen Tischteils Tx3 und des dritten verdrehbaren Tischteils Tφ3 sind jeweils zwei in Differenz geschaltete, induktive Messtaster My3 bzw. Mx3 bzw. Mφ3 vorgesehen, die in der Zeichnung alle nur durch Pfeile angedeutet sind.

Im übrigen entsprechen der Aufbau und die Wirkungsweise des in Fig. 3 dargestellten Justier- oder Positioniertisches einer integrierten Ausführung der in den Fig. 1 und 2 dargestellten Justier- oder Positioniertische. Bei dieser Integration braucht lediglich der fest angeordnete Tischteil T2 gemäss Fig. 2 durch den zweiten, in x-Richtung beweglichen Tischteil Tx1 gemäss Fig. 1 ersetzt zu werden.

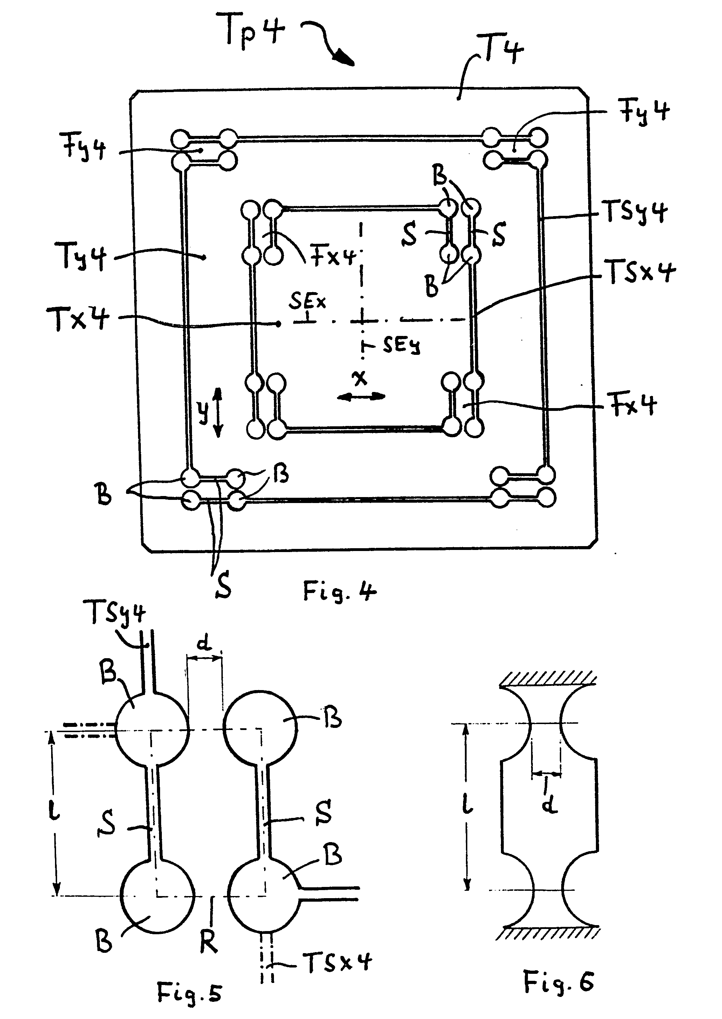

Fig. 4 zeigt einen Justier- oder Positioniertisch, welcher bis auf die Ausgestaltung der Federgelenke und der Trenn-Schlitze dem in Fig. 1 nur schematisch dargestellten Justier- oder Positioniertisch entspricht. Dabei sind aus einer gemeinsamen Tischplatte Tp4 ein fest angeordneter Tischteil T4, ein erster in der y-Richtung beweglicher Tischteil Ty4, ein zweiter in der x-Richtung beweglicher Tischteil Tx4, vier paarweise zwischen dem fest angeordneten Tischteil T4 und dem ersten beweglichen Tischteil Ty4 angeordnete Federgelenke Fy4 und vier weitere, paarweise zwischen dem ersten beweglichen Tischteil Ty4 und dem zweiten beweglichen Tischteil Tx4 angeordnete Federgelenke Fx4 einstückig herausgebildet. Um diese einstückige Ausbildung der vorstehend aufgeführten Teile zu erzielen, werden an den für die Federgelenke Fy4 und Fx4 vorgesehenen Stellen zunächst jeweils vier Bohrungen B senkrecht in die gemeinsame Tischplatte Tp4 eingebracht, wobei die vier Bohrungen B gemäss Fig. 5 genau in den Eckpunkten eines gedachten Rechtecks R liegen. Anschliessend werden jeweils zwei auf der langen Seite des Rechtecks R einander gegenüberliegende Bohrungen B durch zwei parallel zueinander in die gemeinsame Tischplatte Tp4 eingebrachte Schlitze S miteinander verbunden. Ausserdem werden zwischen den fest angeordneten und einen äusseren Rahmen bildenden Tischteil T4 und den ersten beweglichen Tischteil Ty4 Trenn-Schlitze TSy4 und zwischen dem ersten beweglichen Tischteil Ty4 und den zweiten beweglichen Tischteil Tx4 Trenn-Schlitze TSx4 in die gemeinsame Tischplatte Tp4 eingebracht, wobei diese Trenn-Schlitze TSy4 und TSx4 endseitig jeweils ineinander diagonal gegenüberliegende Bohrungen B der Federgelenke Fy4 bzw. Fx4 einmünden. Die Herstellung der Schlitze S und der Trenn-Schlitze TSy4 und TSx4 erfolgt dabei durch Drahterrosion, welche eine präzise Schlitzgeometrie und geringe Schlitzbreiten von beispielsweise 0,5 mm ermöglicht. Durch die geringen Schlitzbreiten werden dann andererseits aber im Hinblick auf die Positionsstabilität bei Temperaturschwankungen günstige grosse Massen der Tischteile realisiert.

Gemäss Fig. 5 entstehen an den kurzen Seiten des strichpunktiert dargestellten Rechtecks R zwischen jeweils zwei Bohrungen B Einschnürungen mit der Dicke d, welche sich als Differenz der Länge der kurzen Seite und des Bohrungsdurchmessers ergibt. Demgegenüber ist der mittlere Bereich der Federgelenke Fy4 oder Fx4 durch den grösseren Abstand der Schlitze S als Verdickung ausgebildet, welche als Versteifung eine Knickung und Torsion verhindern soll. Die Federlänge 1 der Federgelenke Fy4 oder Fx4 sind durch die Länge der langen Seiten des Rechtecks R vorgegeben. In Verbindung mit der in Fig. 6 dargestellten Kontur ist zu erkennen, dass die Federgelenke Fy4 oder Fx4 als beidseitig fest eingespannte Federelemente mit zwei im Abstand 1 voneinander angeordneten, elastisch deformierbaren Drehgelenken wirken. Der Verschiebeweg v von zwei paarig angeordneten und zusammen wie eine fest eingespannte Membran wirkenden Federgelenken Fy4 oder Fx4 lässt sich näherungsweise nach der Formel

$$v = \frac{F \cdot 1^3}{192 \cdot E \cdot I}$$

berechnen, wobei mit F die Verschiebekraft, mit E der Elastizitätsmodul des Werkstoffs der gemeinsamen Tischplatte Tp4 und mit I das Trägheitsmoment der Engstellen bezeichnet ist. Das Trägheitsmoment I wird nach der Formel

$$I = \frac{b \cdot d^3}{12}$$

berechnet, wobei mit d die senkrecht zur Zeichnungsebene gemessene Stärke der gemeinsamen Tischplatte Tp4 bezeichnet ist.

Aufgrund der hohen Präzision, mit welcher die Bohrungen B in die gemeinsame Tischplatte Tp4 eingebracht werden, können gleiche geometrische Bedingungen und gleiche Eigenschaften der vier Federgelenke Fy4 oder der vier Federgelenke Fx4 realisiert und damit genau lineare Verstellungen ermöglicht werden.

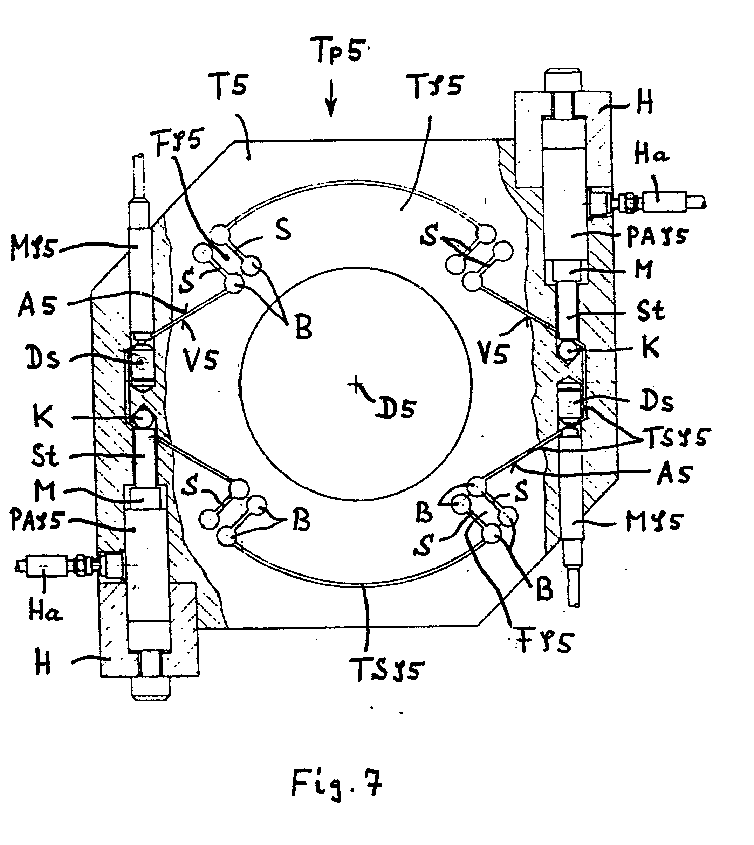

Fig. 7 zeigt einen Justier- oder Positioniertisch, welcher bis auf die Ausgestaltung der Federgelenke und der Trenn-Schlitze im wesentlichen dem in Fig. 2 nur schematisch dargestellten Justier- oder Positioniertisch entspricht. Dabei sind aus der gemeinsamen Tischplatte Tp5 ein fest angeordneter Tischteil T5, ein um eine Drehachse D5 verdrehbarer Tischteil Tφ5 und vier radial ausgerichtete und zwischen dem fest angeordneten Tischteil T5 und dem verdrehbaren Tischteil Tφ5 angeordnete Federgelenke Fφ5 einstückig herausgebildet. Die jeweils durch vier Bohrungen B und zwei Schlitze S gebildeten Federgelenke F5 entsprechen in ihrer Herstellung und in ihrer Kontur dem in den Fig. 5 und 6 dargestellten Federgelenk. Die Bohrungen B und die Schlitze S werden jedoch so in die gemeinsame Tischplatte Tp5 eingebracht, dass sich eine radiale Ausrichtung mit einer in bezug auf die Drehachse D5 rotatorischen Wirkung ergibt. Ausser den Bohrungen B und den Schlitzen S der vier Federgelenke Fφ5 werden in die gemeinsame Tischplatte noch mittels Drahterosion zwischen dem einen äusseren Rahmen bildenden fest angeordneten Tischteil T5 und dem verdrehbaren Tischteil Tφ 5 Trenn-Schlitze TSφ5 eingebracht, wobei diese beispielsweise 0,5 mm breiten Trenn-Schlitze TSφ5 endseitig jeweils in einander diagonal gegenüberliegende Bohrungen B der Federgelenke Fφ5 einmünden. Zwei der Trenn-Schlitze TSφ5 verlaufen dabei in Umfangsrichtung, während die beiden anderen Trenn-Schlitze TSφ5 einen derartigen Verlauf nehmen, dass in Aussparungen A5 des fest angeordneten Tischteils T5 eingreifende Vorsprünge V5 des verdrehbaren Tischteils Tφ5 gebildet werden.

Als Stellantriebe sind zwei Piezo-Antriebe PAφ5 vorgesehen, welche in den fest angeordneten Tischteil T5 eingesetzt und jeweils durch eine brückenförmige Halterung H gehalten sind. Wird an die Hochspannungsanschlüsse Ha der Piezo-Antrieb PAφ5 eine Spannung angelegt, so schieben sich Magnete M aus dem Gehäuse und führen über im Bereich der Aussparungen A5 angeordnete Stössel St und in den Vorsprüngen V5 gelagerte Kugeln K zu einer Drehverstellung des verdrehbaren Tischteils Tφ5 im Uhrzeigersinn. Zur Erfassung der Ist-Position des verdrehbaren Tischteils Tφ5 sind zwei induktive Messtaster Mφ5 vorgesehen, welche den Piezo-Antrieben PA5 gegenüberliegend in den fest angeordneten Tischteil eingesetzt sind. Jedem dieser induktiven Messtaster M5 ist dabei ein in den entsprechenden Vorsprung V5 eingesetztes Druckstück Ds zugeordnet.

Die vorstehend beschriebenen Justier- und Positioniertische können allgemein für Präzisionsverstellungen im Submikrometerbereich eingesetzt werden. Als Anwendungsbeispiele können die Feinjustierung von Maske zu Scheibe bei der Röntgenlithographie, die Feinverstellung des Drehdiamanten bei Feinstdrehmaschinen zur Herstellung von Speicherplatten, die Feinjustierung im Bereich der Lichtwellenleitertechnik und die Feindrehverstellung zur Überprüfung von Autokollimationsfernrohren im Prüfstellenbereich genannt werden.

Der in Fig. 4 dargestellte Justier- oder Positioniertisch wurde aus einer gemeinsamen Tischplatte Tp4 aus Invarstahl mit den Abmessungen 180 mm × 180 mm × 25 mm geformt. Dieser Invarstahl mit einer Zusammensetzung von beispielsweise 63,5% Fe, 36% Ni und 0,5% Mn dehnt sich unter allen Stählen beim Erwärmen am wenigsten aus. Die Bohrungen B der Federgelenke Fy4 und Fx4 wurden mit höchster Präzision gefertigt, während die Schlitze S und die Trenn-Schlitze TSy4 und TSx4 durch Drahterosion mit einer Schlitzbreite von 0,5 mm hergestellt wurden. Der Verstellbereich des Justier- oder Positioniertisches beträgt in x-Richtung und in y-Richtung jeweils 10 µm. Der kleinste angezeigte Bewegungsschritt liegt bei 0,005 µm. Die erzielte Führungsgenauigkeit ergibt Geradlinigkeitsabweichungen in x-Richtung und in y-Richtung von weniger als +0,03 µm. Die Prüfung der Langzeitstabilität in einem auf ± 0,1 °C klimatisierten Raum ergab nach einer Akklimatisationszeit von 2 Tagen Massabweichungen von weniger als ± 0,01 µm.

Der in Fig. 7 dargestellte Justier- oder Positioniertisch wurde aus einer gemeinsamen Tischplatte Tp5 aus Invarstahl mit den Abmessungen 180 mm × 180 mm × 20 mm durch Einbringen der Bohrungen B und durch Herstellung der Schlitze S und der Trenn-Schlitze Ts5φ mittels Drahterosion geformt. Der Verstellbereich beträgt in Drehrichtung ± 40″. Der kleinste angezeigte Bewegungsschritt liegt bezogen auf einen Hebelarm von 73 mm bei 0,05 µm. Die erzielte Führungsgenauigkeit ergibt bei Drehung eine Drehachsenverlagerung von weniger als ± 0,03 µm. Die Prüfung der Langzeitstabilität in einem auf ± 0,1 °C klimatisierten Raum ergab nach einer Akklimatisationszeit von 2 Tagen bezogen auf einen Hebelarm von 73 mm Massabweichungen von weniger als ± 0,01 µm.

**Patentansprüche**

1. Justier- oder Positioniertisch, insbesondere für Feinverstellungen im Submikrometerbereich, mit einem fest angeordneten Tischteil, mindestens einem relativ zum fest angeordneten Tischteil beweglichen Tischteil, mindestens einem auf den beweglichen Tischteil in Bewegungsrichtung einwirkenden Stellantrieb und mit einer federelastischen Verbindung von fest angeordnetem Tischteil und beweglichem Tischteil durch quer zur Bewegungsrichtung ausgerichtete und in Bewegungsrichtung auslenkbare Federgelenke, dadurch gekennzeichnet, dass der fest angeordnete Tischteil (T1; T2; T3; T4; T4), der bewegliche Tischteil (Ty1; Tφ2; Ty3; Ty4; Tφ5) und mindestens vier, paarweise auf gegenüberliegenden Seiten des beweglichen Tischteils (Ty1; Tφ2; Ty3; Ty4; Tφ5) angeordnete Federgelenke (Fy1; Fφ2; Fy3; Fy4; Fφ5) einstückig aus einer gemeinsamen Tischplatte (Tp1; Tp2; Tp3; Tp4; Tp5) durch Bildung von Schlitzen in derselben herausgebildet sind.

2. Justier- oder Positioniertisch nach Anspruch 1, dadurch gekennzeichnet, dass zwischen den fest angeordneten Tischteil (T1; T2; T3; T4; T5) und den beweglichen Tischteil (Ty1; Tφ2; Ty3; Ty4; Tφ5) sich zwischen den Federgelenken (Fy1; Fφ2; Fy3; Fy4; Fφ5) erstreckende Trenn-Schlitze (TSy1; TSφ2; TSy3; TSy4; TSφ5) in die gemeinsame Tischplatte (Tp1; Tp2; Tp3; Tp4; Tp5) eingebracht sind.

3. Justier- oder Positioniertisch nach Anspruch 1 oder 2, dadurch gekennzeichnet, dass der bewegliche Tischteil (Ty1; Ty3; Ty4) relativ zum fest angeordneten Tischteil (T1; T3; T4) linear verstellbar ist und dass die Federgelenke (Fy1; Fy3; Fy4) spiegelsymmetrisch zu einer in der Bewegungsrichtung (y) des beweglichen Tischteils (Ty1; Ty3; Ty4) liegenden Symmetrie-Ebene (SEy) der gemeinsamen Tischplatte (Tp1; Tp3; Tp4) angeordnet sind.

4. Justier- oder Positioniertisch nach Anspruch 1 oder 2, dadurch gekennzeichnet, dass der bewegliche Tischteil (Tφ2; Tφ5) relativ zum fest angeordneten Tischteil (T2; T5) verdrehbar ist und dass die Federgelenke (Fφ2; Fφ5) in bezug auf die Drehachse (D2; D5) des beweglichen Tischteils (Tφ2; Tφ5) radial ausgerichtet und rotationssymmetrisch angeordnet sind.

5. Justier- oder Positioniertisch nach einem der Ansprüche 1 bis 3, dadurch gekennzeichnet, dass aus der gemeinsamen Tischplatte (Tp1; Tp3; Tp4) zusätzlich ein zweiter beweglicher Tischteil (Tx1; Tx3; Tx4) sowie mindestens vier weitere, paarweise zwischen dem beweglichen Tischteil (Ty1; Ty3; Ty4) und dem zweiten beweglichen Tischteil (Tx1; Tx3; Tx4) angeordnete Federgelenke (Fx1; Fx3; Fx4) einstückig herausgebildet sind, wobei die weiteren Federgelenke (Fx1; Fx3; Fx4) quer zur Bewegungsrichtung (x) des zweiten beweglichen Tischteils (Tx1; Tx3; Tx4) ausgerichtet und in Bewegungsrichtung (x) des zweiten beweglichen Tischteils (Tx1; Tx3; Tx4) auslenkbar sind.

6. Justier- oder Positioniertisch nach Anspruch 5, dadurch gekennzeichnet, dass zwischen den beweglichen Tischteil (Ty1; Ty3; Ty4) und den zweiten beweglichen Tischteil (Tx1; Tx3; Tx4) sich zwischen den weiteren Federgelenken (Fx1; Fx3; Fx4) erstreckende Trenn-Schlitze (TSx1; TSx3; TSx4) in die gemeinsame Tischplatte (Tp1; Tp3; Tp4) eingebracht sind.

7. Justier- oder Positioniertisch nach Anspruch 5 oder 6, dadurch gekennzeichnet, dass der zweite bewegliche Tischteil (Tx1; Tx3; Tx4) relativ zum beweglichen Tischteil (Ty1; Ty3; Ty4) linear verstellbar ist und dass die weiteren Federgelenke (Fx1; Fx3; Fx4) spiegelsymmetrisch zu einer in der Bewegungsrichtung (x) des zweiten beweglichen Tischteils (Tx1; Tx3; Tx4) liegenden Symmetrie-Ebene (SEx) der gemeinsamen Tischplatte (Tp1; Tp3; Tp4) angeordnet sind.

8. Justier- oder Positioniertisch nach einem der Ansprüche 5 bis 7, dadurch gekennzeichnet, dass aus der gemeinsamen Tischplatte (Tp3) zusätzlich ein relativ zum zweiten beweglichen Tischteil (Tx3) verdrehbarer dritter beweglicher Tischteil (Tφ3) sowie mindestens vier zusätzliche, paarweise zwischen dem zweiten beweglichen Tischteil (Tx3) und dem dritten beweglichen Tischteil (Tφ3) angeordnete Federgelenke (Fφ3) einstückig herausgebildet sind, wobei die zusätzlichen Federgelenke (Fφ3) radial zur Drehachse (D3) des dritten beweglichen Tischteils (Tφ3) ausgerichtet und in Umfangsrichtung auslenkbar sind.

9. Justier- oder Positioniertisch nach Anspruch 8, dadurch gekennzeichnet, dass zwischen den zweiten beweglichen Tischteil (Tx3) und den dritten beweglichen Tischteil (Tφ3) sich zwischen den zusätzlichen Federgelenken (Fφ3) erstreckende Trenn-Schlitze (TSφ3) in die gemeinsame Tischplatte (Tp3) eingebracht sind.

10. Justier- oder Positioniertisch nach Anspruch 8 oder 9, dadurch gekennzeichnet, dass die zusätzlichen Federgelenke (Fφ3) in bezug auf die Drehachse (D3) des dritten beweglichen Tischteils (Tφ3) rotationssymmetrisch angeordnet sind.

11. Justier- oder Positioniertisch nach einem der vorhergehenden Ansprüche, dadurch gekennzeichnet, dass die Federgelenke (Fy4, Fx4; Fφ5) durch Verdickungen im mittleren Bereich versteift sind.

12. Justier- oder Positioniertisch nach Anspruch 11, dadurch gekennzeichnet, dass die Federgelenke (Fy4, Fx4; Fφ5) jeweils durch vier in den Eckpunkten eines Rechtecks (R) in die gemeinsame Tischplatte (Tp4; Tp5) eingebrachte Bohrungen (B) und durch zwei parallel zueinander in die gemeinsame Tischplatte (Tp4; Tp5) eingebrachte und jeweils zwei Bohrungen (B) miteinander verbindende Schlitze (S) gebildet sind.

13. Justier- oder Positioniertisch nach Anspruch 12 sowie einem oder mehreren der Ansprüche 2, 6 und 9, dadurch gekennzeichnet, dass die Trenn-Schlitze (TSy4, TSx4; TSφ5) in einander diagonal gegenüberliegende Bohrungen (B) einmünden.

14. Justier- oder Positioniertisch nach einem der vorhergehenden Ansprüche, dadurch gekennzeichnet, dass der fest angeordnete Tischteil (T1; T2; T3; T4; T5) als äusserer Rahmen des beweglichen Tischteils (Ty1; Tφ2; Ty3; Ty4; Ty5) ausgebildet ist.

15. Justier- oder Positioniertisch nach einem der vorhergehenden Ansprüche, dadurch gekennzeichnet, dass jedem beweglichen Tischteil (Ty1, Tx1; Tφ2; Ty3, Tx3, Tφ3; Tφ5) mindestens ein Piezo-Antrieb (PAy1, PAx1; PAφ2; PAy3, PAx3, PAφ3, PAφ5) als Stellantrieb zugeordnet ist.

16. Justier- oder Positioniertisch nach einem der vorhergehenden Ansprüche, dadurch gekennzeichnet, dass die Ist-Position jedes beweglichen Tischteils (Ty1, Tx1; Tφ2; Ty3, Tx3, Tφ3; Tφ5) jeweils durch zwei in Differenz geschaltete induktive Messtaster (My1, Mx1; Mφ2; My3, Mx3, Mφ3; Mφ5) erfassbar ist.

17. Justier- oder Positioniertisch nach einem der vorhergehenden Ansprüche, dadurch gekennzeichnet, dass die gemeinsame Tischplatte (Tp1; Tp2; Tp3; Tp4; Tp5) aus einem Material mit geringem Wärmeausdehnungskoeffizienten besteht.

18. Justier- oder Positioniertisch nach Anspruch 17, dadurch gekennzeichnet, dass die gemeinsame Tischplatte (Tp1; Tp2; Tp3; Tp4; Tp5) aus Invarstahl besteht.

19. Verfahren zur Herstellung eines Justier- oder Positioniertisches, insbesondere für Feinverstellungen im Submikrometerbereich, mit einem fest angeordneten Tischteil, mindestens einem relativ zum fest angeordneten Tischteil beweglichen Tischteil, mindestens einem auf den beweglichen Tischteil in Bewegungsrichtung einwirkenden Stellantrieb und mit einer federelastischen Verbindung von fest angeordnetem Tischteil und beweglichem Tischteil durch quer zur Bewegungsrichtung ausgerichtete und in Bewegungsrichtung auslenkbare Federgelenke, dadurch gekennzeichnet, dass aus einer gemeinsamen Tischplatte (Tp1; Tp2; Tp3, Tp4, Tp5) ein fest angeordneter Tischteil (T1; T2; T3; T4; T5), mindestens ein beweglicher Tischteil (Ty1; Tφ2; Ty3; Ty4; Tφ5) und mindestens vier zwischen dem fest angeordneten Tischteil (T1; T2; T3; T4; T5) und dem beweglichen Tischteil (Ty1; Tφ2; Ty3; Ty4; Tφ5) angeordnete Federgelenke (Fy1; Fφ2; Fy3; Fy4; Fφ5) durch Funkenerosion einstückig herausgebildet werden.

20. Verfahren nach Anspruch 19, dadurch gekennzeichnet, dass aus der gemeinsamen Tischplatte (Tp1; Tp3; Tp4) mindestens ein weiterer beweglicher Tischteil (Tx1; Tx3; Tx4) und mindestens vier weitere, zwischen dem beweglichen Tischteil (Ty1; Ty3; Ty4) und dem weiteren beweglichen Tischteil (Tx1; Tx3; Tx4) angeordnete Federgelenke (Fx1; Fx3; Fx4) durch Funkenerosion einstückig herausgebildet werden.

21. Verfahren nach Anspruch 19 oder 20, dadurch gekennzeichnet, dass zwischen die einzelnen Tischteile T1; Ty1; Tx; T2, Tφ2; T3, Ty3, Tx3; T4, Ty4, Tx4; T5, Tφ5) sich zwischen den Federgelenken (Fy1, Fx1; Fφ2; Fy3, Fx3; Fy4, Fx4; Fφ5) erstreckende Trenn-Schlitze (TSy1, TSx1; TSφ2; TSx3, TSφ3; TSy4, TSx4; TSφ5) in die gemeinsame Tischplatte (Tp1; Tp2; Tp3; Tp4; Tp5) durch Drahterosion eingebracht werden.

22. Verfahren nach einem der Ansprüche 19 bis 21, dadurch gekennzeichnet, dass die Federgelenke (Fy4, Fx4; Fφ5) jeweils durch das Einbringen von vier in den Eckpunkten eines Rechtecks (R) angeordneten Bohrungen (B) in die gemeinsame Tischplatte (Tp4; Tp5) und durch das Verbinden von jeweils zwei dieser Bohrungen über zwei parallele, durch Drahterosion in die gemeinsame Tischplatte (Tp4; Tp5) eingebrachte Schlitze (S) hergestellt werden.

**Claims**

1. An adjusting or positioning table, in particular for fine adjustments in the sub-micrometer range, comprising a fixed table component, at least one table component which is movable relative to the fixed table component, at least one actuating drive which acts upon the movable table component in the direction of movement and a resilient connection between the fixed table component and the movable table component consisting of resilient links which are aligned transversely to the direction of movement and are deflectable in the direction of movement, characterized in that the fixed table component (T1; T2; T3; T4; T5), the movable table component (Ty1; Tφ2; Ty3; Ty4; Tφ5) and at least for resilient links (Fy1; Fφ2; Fy3; Fy4; Fφ5), arranged in pairs on opposite sides of the movable table component (Ty1; Tφ2; Ty3; Ty4; Tφ5) are integrally formed from a common table top (Tp1; Tp2; Tp3; Tp4; Tp5) by the formation of slots therein.

2. An adjusting or positioning table as claimed in claim 1, characterized in that between the fixed table component (T1; T2; T3; T4; T5) and the movable table component (Ty1; Tφ2; Ty3; Ty4; Tφ5), separating slots (TSy1; TSφ2; TSy3; TSy4; TSφ5), which extend between the resilient links (Fy1; Fφ2; Fy3; Fy4; Fφ5), are formed in the common table top (Tp1; Tp2; Tp3; Tp4; Tp5).

3. An adjusting or positioning table as claimed in claim 1 or 2, characterized in that the movable table component (Ty1; Ty3; Ty4) is linearly adjustable relative to the fixed table component (T1; T3; T4) and that the resilient links (Fy1; Fy3; Fy4) are arranged symmetrically about a plane of symmetry (SEy) located in the direction of movement (y) of the movable table component (Ty1; Ty3; Ty4), of the common table top (Tp1; Tp3; Tp4).

4. An adjusting or positioning table as claimed in claim 1 or 2, characterized in that the movable table component (Tφ2; Tφ5) is rotatable relative to the fixed table component (T2; T5) and that the resilient links (Fφ2; Fφ5) are radially aligned relative to the axis of rotation (D2; D5) of the movable table component (Tφ2; Tφ5) and are arranged so as to be axisymmetrical.

5. An adjusting or positioning table as claimed in one of claims 1 to 3, characterized in that a second movable table component (Tx1; Tx3; Tx4) and at least four further resilient links (Fx1; Fx3; Fx4), arranged in pairs between the movable table component (Ty1; Ty3; Ty4) and the second movable table component (Tx1; Tx3; Tx4), are additionally integrally formed from the common table top (Tp1; Tp3; Tp4), where the further resilient links (Fx1; Fx3; Fx4) are aligned transverse to the direction of movement (x) of the second movable table component (Tx1; Tx3; Tx4) and are deflectable in the direction of movement (x) of the second movable table component (Tx1; Tx3; Tx4).

6. An adjusting or positioning table as claimed in claim 5, characterized in that between the movable table component (Ty1; Ty3; Ty4) and the second movable table component (Tx1; Tx3; Tx4), separating slots (TSx1; TSx3; TSx4), which extend between the further resilient links (Fx1; Fx3; Fx4), are formed in the common table top (Tp1; Tp3; Tp4).

7. An adjusting or positioning table as claimed in claim 5 or 6, characterized in that the second movable table component (Tx1; Tx3; Tx4) is linearly adjustable relative to the movable table component (Ty1; Ty3; Ty4) and that the further resilient links (Fx1; Fx3; Fx4) are arranged so as to be symmetrical about a plane of symmetry (SEx), located in the direction of movement (x) of the second movable table component (Tx1; Tx3; Tx4), of the common table top (Tp1; Tp3; Tp4).

8. An adjusting or positioning table as claimed in one of claims 5 to 7, characterized in that a third movable table component (Tφ3), which is rotatable relative to the second movable table component (Tx3), and at least four additional resilient links (Fφ3), arranged in pairs between the second movable table component (Tx3) and the third movable table component (Tφ3), are additionally integrally formed from the common table top (Tp3), where the additional resilient links (Fφ3), are aligned radially to the axis of rotation (D3) of the third movable table component (Tφ3) and are deflectable in the peripheral direction.

9. An adjusting or positioning table as claimed in claim 8, characterized in that between the second movable table component (Tx3) and the third movable table component (Tφ3), separating slots (TSφ3), which extend between the additional resilient links (Fφ3), are formed in the common table top (Tp3).

10. An adjusting or positioning table as claimed in claim 8 or 9, characterized in that the additional resilient links (Fφ3) are arranged to be axisymmetrical relative to the axis of rotation (D3) of the third movable table component (Tφ3).

11. An adjusting or positioning table as claimed in one of the preceding claims, characterized in that the resilient links (Fy4, Fx4; Fφ5) are stiffened by thickened portions in the central region.

12. An adjusting or positioning table as claimed in claim 11, characterized in that the resilient links (Fy4, Fx4; Fφ5) are each formed by four bores (B) which are formed in the common table top (Tp4; Tp5) at the corner points of a rectangle (R), and by two mutually parallel slots (S) which are formed in the common table top (Tp4; Tp5) and which each connect two bores (B) to one another.

13. An adjusting or positioning table as claimed in claim 12 and one or more of claims 2, 6 and 9, characterized in that the separating slots (TSy4, TSx4; TSφ5) lead into bores (B) arranged diagonally opposite one another.

14. An adjusting or positioning table as claimed in one of the preceding claims, characterized in that the fixed table component (T1; T2; T3; T4; T5) forms the outer frame of the movable table component (Ty1; Tφ2; Ty3; Ty4; Tφ5).

15. An adjusting or positioning table as claimed in one of the preceding claims, characterized in that each movable table component (Ty1, Tx1; Tφ2; Ty3, Tx3, Tφ3; Tφ5) is assigned at least one piezo-drive (PAy1, PAx1; PAφ2; PAy3, PAx3, PAφ3, PAφ5) as its actuating drive.

16. An adjusting or positioning table as claimed in one of the preceding claims, characterized in that the actual position of each movable table component (Ty1, Tx1; Tφ2; Ty3, Tx3, Tφ3; Tφ5) can in each case be detected by two inductive measuring sensors (My1, Mx1; Mφ2; My3, Mx3, Mφ3; Mφ5) connected in opposition.

17. An adjusting or positioning table as claimed in one of the preceding claims, characterized in that the common table top (Tp1; Tp2; Tp3; Tp4; Tp5) consists of a material which has a low heat expansion coefficient.

18. An adjusting or positioning table as claimed in claim 17, characterized in that the common table top (Tp1; Tp2; Tp3; Tp4; Tp5) consists of invar steel.

19. A process for the production of an adjusting or positioning table, in particular for fine adjustment in the sub-micro-meter range, comprising a fixed table component, at least one table component which is movable relative to the fixed table component, at least one actuating drive which acts upon the movable table component in the direction of movement and a resilient connection between the fixed table component and the movable table component which consists of resilient links which are aligned transversely to the direction of movement and which are deflectable in the direction of movement, characterized in that a fixed table component (T1; T2; T3; T4; T5), at least one movable table component (Ty1; Tφ2; Ty3; Ty4; Tφ5), and at least four resilient links (Fy1; Fφ2; Fy3; Fy4; Fφ5), arranged between the fixed table component (T1; T2; T3; T4; T5) and the movable table component (Ty1; Tφ2; Ty3; Ty4; Tφ5), are integrally formed by spark erosion from a common table top (Tp1; Tp2; Tp3; Tp4, Tp5).

20. A process as claimed in claim 19, characterized in that at least one further movable table component (Tx1; Tx3; Tx4) and at least four further resilient links (Fx1; Fx3; Fx4), arranged between the movable table component (Ty1; Ty3; Ty4) and the further movable table component (Tx1; Tx3; Tx4), are integrally formed by spark erosion from the common table top (Tp1; Tp3; Tp4).

21. A process as claimed in claim 19 or 20, characterized in that between the individual table components (T1; Ty1; Tx1, T2, Tφ2; T3, Ty3, Tx3; T4, Ty4, Tx4, T5, Tφ5), separating slots (TSy1, TSx1; TSφ2; TSy3, TSx3, TSφ3; TSy4, TSx4; TSφ5), which extend between the resilient links (Fy1, Fx1; Fφ2; Fy3, Fx3; Fy4, Fx4, Fφ5), are introduced into the common table top (Tp1; Tp2; Tp3; Tp4; Tp5) by wire erosion.

22. A process as claimed in one of claims 19 to 21, characterized in that the resilient links (Fy4, Fx4; Fφ5) are each produced by forming four bores (B), arranged at the corner points of a rectangle (R), in the common table top (Tp4; Tp5) and by connecting in each case two of these bores via two parallel slots (S) introduced into the common table top (Tp4; Tp5) by wire erosion.

## Revendications

1. Table d'ajustement ou de positionnement, en particulier pour des réglages fins dans le domaine au-dessous du micromètre, comprenant une partie de table disposée fixe, au moins une partie de table mobile par rapport à la partie fixe, au moins une commande de déplacement agissant dans le sens de mouvement sur la partie mobile et une liaison ayant l'élasticité d'un ressort, constituée entre la partie fixe et la partie mobile de la table par des articulations à ressort orientées transversalement à la direction de mouvement et pouvant être déviées dans le sens de mouvement, caractérisée en ce que la partie de table (T1; T2; T3; T4; T5) disposée fixe, la partie de table mobile (Ty1; Tφ2; Ty3; Ty4; Tφ5) et au moins quatre articulations à ressort (Fy1; Fφ2; Fy3; Fy4; Fφ5), disposées par paires sur des côtés opposés de la partie de table mobile (Ty1; Tφ2; Ty3; Ty4; Tφ5), sont formées d'un seul tenant d'une plaque de table unique ou commune (Tp1; Tp2; Tp3; Tp4; Tp5) par formation de fentes dans cette plaque de table.

2. Table selon la revendication 1, caractérisée en ce que des fentes de séparation (TSy1; TSφ2; TSy3; TSy4; TSφ5), s'étendant entre les articulations à ressort (Fy1; Fφ2; Fy3; Fy4; Fφ5), ont été ménagées dans la plaque de table unique (Tp1; Tp2; Tp3; Tp4; Tp5) entre la partie de table fixe (T1; T2; T3; T4; T5) et la partie de table mobile (Ty1; Tφ2; Ty3; Ty4; Tφ5).

3. Table selon la revendication 1 ou 2, caractérisée en ce que la partie mobile (Ty1; Ty2; Ty4) est déplaçable linéairement par rapport à la partie fixe (T1; T3; T4) et que les articulations à ressort (Fy1; Fy3; Fy4) sont disposées de part et d'autre et symétriquement par rapport à un plan de symétrie (SEy), s'étendant dans la direction de mouvement (y) de la partie de table mobile (Ty1; Ty3; Ty4), de la plaque de table unique (Tp1; Tp3; Tp4).

4. Table selon la revendication 1 ou 2, caractérisée en ce que la partie mobile (Tφ2; Tφ5) est rotative par rapport à la partie fixe (T2; T5) de la table et que les articulations à ressort (Fφ2; Fφ5) sont orientées radialement et sont disposées à symétrie de révolution par rapport à l'axe de rotation (D2; F5) de la partie mobile (Tφ2; Tφ5) de la table.

5. Table selon une des revendications 1 à 3, caractérisée en ce qu'une deuxième partie de table mobile (Tx1; Tx3; Tx4) est formée, en plus, d'un seul tenant, de la plaque de table unique (Tp1; Tp3; Tp4), ainsi qu'au moins quatre articulations à ressort (Fx1; Fx3; Fx4) disposées par paires entre la partie de table mobile (Ty1; Ty3; Ty4) et la deuxième partie de table mobile (Tx1; Tx3; Tx4), les articulations à ressort supplémentaires (Fx1; Fx3; Fx4) étant orientées transversalement à la direction de mouvement de la deuxième partie mobile (Tx1; Tx3; Tx4) et pouvant être déviées dans la direction de mouvement (x) de la deuxième partie mobile (Tx1; Tx3; Tx4) de la table.

6. Table selon la revendication 5, caractérisée en ce que des fentes de séparation (TSx1; TSx3; TSx4), s'étendant entre les articulations à ressort supplémentaires (Fx1; Fx3; Fx4), sont ménagées dans la plaque de table unique (Tp1; Tp3; Tp4) entre la partie mobile (Ty1; Ty3; Ty4) et la deuxième partie mobile (Tx1; Tx3; Tx4) de la table.

7. Table selon la revendication 5 ou 6, caractérisée en ce que la deuxième partie mobile (Tx1; Tx3; Tx4) est déplaçable linéairement par rapport à la partie de table mobile (Ty1; Ty3; Ty4) et que les articulations à ressort supplémentaires (Fx1; Fx3; Fx4) sont disposées symétriquement de part et d'autre d'un plan de symétrie (SEx) de la plaque de table unique (Tp1; Tp3; Tp4), plan qui s'étend dans la direction de mouvement (x) de la deuxième partie mobile (Tx1; Tx3; Tx4) de la table.

8. Table selon une des revendications 5 à 7, caractérisée en ce qu'une troisième partie de table mobile (Tφ3), qui est rotative par rapport à la deuxième partie mobile (Tx3), est formée en plus, également d'un seul tenant, de la plaque de table unique (Tp3), ainsi qu'au moins quatre articulations à ressort (Fφ3) supplémentaires, disposées par paires entre la deuxième partie mobile (Tx3) et la troisième partie mobile (Tφ3) de la table, les articulations supplémentaires (Fφ3) étant orientées radialement par rapport à l'axe de rotation (D3) de la troisième partie mobile (Tφ3) et pouvant être déviées dans le sens circonférentiel.

9. Table selon la revendication 8, caractérisée en ce que des fentes de séparation (TSφ3), s'étendant entre les articulations à ressort supplémentaires (Fφ3), sont ménagées dans la plaque de table unique (Tp3) entre la deuxième partie mobile (Tx3) et la troisième partie mobile (Tφ3).

10. Table selon la revendication 8, caractérisée en ce que les articulations à ressort supplémentaires (Fφ3) sont disposées à symétrie de rotation par rapport à l'axe de rotation (D3) de la troisième partie mobile (Tφ3) de la table.

11. Table selon une des revendications précédentes, caractérisée en ce que les articulations à ressort (Fy4, Fx4; Fφ5) sont raidies par des épaississements dans la zone centrale.

12. Table selon la revendication 11, caractérisée en ce que les articulations à ressort (Fy4, Fx4; Fφ5) sont formées chacune par quatre trous (B) percés aux sommets d'une rectangle (R) dans la plaque de table unique (Tp4; Tp5) et par deux fentes (S) ménagées parallèlement dans la plaque de table unique (Tp4; Tp5) et reliant chacune deux trous (B) entre eux.

13. Table selon la revendication 12 et une ou plusieurs des revendications 2, 6 et 9, caractérisée en ce que les fentes de séparation (TSy4, TSx4; TSφ5) débouchent dans des trous (B) diagonalement opposés.

14. Table selon une des revendications précédentes, caractérisée en ce que la partie de table disposée fixe (T1; T2; T3; T4; T5) est réalisée comme un cadre extérieur de la partie de table mobile (Ty1; Tφ2; Ty3; Ty4; Tφ5).

15. Table selon une des revendications précédentes, caractérisée en ce qu'une commande piézoélectrique (PAy1, PAx1; PAφ2; PAy3, PAx3, PAφ3, PAφ5) au moins est coordonnée en tant que commande de déplacement à chaque partie de table mobile (Ty1, Tx1; Tφ2; Ty3, Tx3, Tφ3; Tφ5).

16. Table selon une des revendications précédentes, caractérisée en ce que la position effective de chaque partie de table mobile (Ty1, Tx1; Tφ2; Ty3, Tx3, Tφ3; Tφ5) est détectable par deux capteurs inductifs (My1; Mx1; Mφ2; My3, Mx3, Mφ3; Mφ5) dans un montage différentiel.

17. Table selon une des revendications précédentes, caractérisée en ce que la plaque de table unique (Tp1; Tp2; Tp3; Tp4; Tp5) est formée d'un matériau à faible coefficient de dilatation thermique.

18. Table selon la revendication 17, caractérisée en ce que la plaque de table (Tp1; Tp2; Tp3; Tp4; Tp5) est en «Invar».

19. Procédé pour la fabrication d'une table d'adjustement ou de positionnement, en particulier pour des réglages fins dans le domaine au-dessous du micromètre, comprenant une partie de table disposée fixe, au moins une partie de table mobile par rapport à la partie fixe, au moins une commande de déplacement agissant dans le sens de mouvement sur la partie mobile et une liaison ayant l'élasticité d'un ressort, constituée entre la partie fixe et la partie mobile de la table par des articulations à ressort orientées transversalement à la direction de mouvement et pouvant être déviées dans le sens de mouvement, caractérisé en ce qu'il consiste à former d'un seul tenant, par électroérosion, dans une plaque de table unique (Tp1; Tp2; Tp3, Tp4, Tp5), une partie de table disposée fixe (T1; T2; T3; T4; T5), au moins une partie de table mobile (Ty1; Tφ2; Ty3; Ty4; Tφ5) et au moins quatre articulations à ressort (Fy1; Fφ2; Fy3; Fy4; Fφ5) disposées entre la partie fixe (T1; T2; T3; T4; T5) et la partie mobile (Ty1; Tφ2; Ty3; Ty4; Tφ5) de la table.

20. Procédé selon la revendication 19, caractérisé en ce que l'on forme, par électroérosion, au moins une autre partie de table mobile (Tx1; Tx3; Tx4) d'un seul tenant de la plaque de table unique (Tp1; Tp3; Tp4), ainsi qu'au moins quatre autres articulations à ressort (Fx1; Fx3; Fx4) disposées entre la partie de table mobile (Ty1; Tx3; Tx4) et la partie mobile supplémentaire (Tx1; Tx3; Tx4).

21. Procédé selon la revendication 19 ou 20, caractérisé en ce que l'on forme, dans la plaque de table unique (Tp1; Tp2; Tp3; Tp4; Tp5) par usinage par fil, des fentes de séparation (TSy1, TSx1; TSφ2; TSy3, TSx3, TSφ3; TSy4, TSx4; TSφ5), s'étendant entre les articulations à ressort (Fy1; Fx1; Fφ2; Fy3; Fx3; Fy4; Fx4, Fφ5), entre les différentes parties (T1; Ty1; Tx1; T2, Tφ2; T3, Ty3, Tx3; T4, Ty4, Tx4; T5, Tφ5) de la table.

22. Procédé selon une des revendications 19 à 21, caractérisé en ce que l'on forme chacune des articulations à ressort (Fy4; Fx4; Fφ5) par le perçage de quatre trous (B) aux sommets d'un rectangle (R) dans la plaque de table unique (Tp4; Tp5) et par l'usinage par fil, dans la plaque de table unique (Tp4; Tp5), de deux fentes (S) parallèles reliant chacune deux des trous (B).

0134268

Fig. 1

Fig. 2

11

# FIG 3

Fig. 4

Fig. 5

Fig. 6

Fig. 7